(19) Europäisches Patentamt

European Patent Office

Office européen des brevets

(11) EP 0 666 244 B1

## (12) FASCICULE DE BREVET EUROPEEN

(45) Date de publication et mention
de la délivrance du brevet:
**20.10.1999 Bulletin 1999/42**

(51) Int. Cl.[6]: **C04B 35/499**, H01B 3/12

(21) Numéro de dépôt: **95400184.8**

(22) Date de dépôt: **27.01.1995**

(54) **Céramique ferroélectrique**

Ferroelektrische Keramik

Ferro-electric ceramic

(84) Etats contractants désignés:
**DE GB**

(30) Priorité: **04.02.1994 FR 9401268**

(43) Date de publication de la demande:
**09.08.1995 Bulletin 1995/32**

(73) Titulaire: **THOMSON-CSF**
**75008 Paris (FR)**

(72) Inventeurs:
• **Gaucher, Philippe**
**F-92402 Courbevoie Cédex (FR)**
• **Deljurie, Claude**
**F-92402 Courbevoie Cédex (FR)**

• **Noblanc, Olivier**
**F-92402 Courbevoie Cédex (FR)**

(56) Documents cités:
**EP-A- 0 180 132        DE-A- 3 924 563**
**US-A- 4 339 544**

• **MATERIALS LETTERS, vol.16, no.5, Mai 1993,**
**AMSTERDAM,NL pages 281 - 285, XP381040**
**S.SHARMA ET AL. 'DIFFUSE PHASE**
**TRANSITION IN SOLID SOLUTION OF...'**
• **R.J.BROOK (EDITOR) 'CONCIDE**
**ENCYCLOPAEDIA OF ADVANCED CERAMIC**
**MATERIALS' , PERGAMON PRESS * page 154,**
**ligne 1, alinéa 3 - ligne 17, alinéa 3 ***
• **S.W.Choi et al., Ferroelectrics 1989, 100, 29-38**

## Description

L'invention concerne une céramique ferroélectrique applicable pour la réalisation d'une céramique piézoélectrique.

Les céramiques piézoélectriques sont utilisées dans de nombreux dispositifs électromécaniques pour capter des contraintes mécaniques ou des ondes sonores par l'effet piézoélectrique direct ou pour générer des déplacements ou des vibrations par l'effet piézoélectrique inverse.

Le premier effet (direct) permet d'induire un champ $E_i$ (ou une polarisation $P_i$) dans la direction i du matériau sous l'effet d'une contrainte $T_j$ orientée dans la direction j :

$$E_i = g_{ij} T_j$$

(ou $P_i = d_{ij} T_j$)

Le coefficient $g_{ij}$ est appelé coefficient de tension piézoélectrique (exprimé en $V.m.N^{-1}$ ou en $m^2.C^{-1}$). Le coefficient $d_{ij}$ est appelé coefficient de charge piézoélectrique (exprimé en $m.V^{-1}$ ou $C.N^{-1}$).

L'effet inverse permet d'induire une déformation $S_i$ dans la direction i du matériau sous l'effet d'un champ électrique $E_j$ (ou d'une polarisation $P_j$) appliqué dans la direction j :

$$S_i = d_{ij} E_j$$

(ou $S_i = g_{ij}.P_j$)

Pour générer de grands déplacements avec une tension faible et un composant de dimension réduite, il faut donc que le coefficient $d_{ij}$ soit le plus élevé possible, en particulier dans les modes longitudinal ($d_{33}$), transverse ($d_{31}$) et hydrostatique ($d_h = d_{33} + 2d_{31}$).

Les céramiques ferroélectriques peuvent être rendues piézoélectriques par un traitement dit de polarisation : cela consiste à appliquer un fort champ électrique à température supérieure à l'ambiante pendant un temps donné. On peut aussi refroidir sous champ depuis une température supérieure à la température de la transition de phase ferroélectrique-paraélectrique.

Pendant ce traitement de polarisation, les domaines ferroélectriques, qui sont désordonnés initialement, s'alignent dans les directions cristallographiques les plus proches de celle du champ appliqué. Cela permet à la céramique d'avoir une polarisation macroscopique non nulle. Cette polarisation est responsable de la piézoélectricité. On souhaite donc qu'elle soit la plus élevée possible et qu'elle se conserve dans le temps.

Le titanate de plomb $PbTiO_3$ ou PT a une très forte polarisation spontanée $P_s$ (environ $60 \ 10^{-6} \ C.m^2$), mais sa structure cristallographique (tétragonale) n'autorise que 6 directions pour la polarisation spontanée $P_s$, ce qui le rend difficile à polariser. Le magno-niobate de plomb ou PMN est un ferroélectrique de type "relaxor" ou à transition diffuse. Pour ces matériaux, la polarisation spontanée n'existe que dans des nanodomaines qui interagissent peu les uns avec les autres. Il en résulte une très forte polarisation induite par de faibles champs (dans les 8 directions de la structure rhomboédrique), mais qu'on ne peut conserver à champ nul.

L'invention concerne donc un céramique ferroélectrique de formule :

$$xPT-yPMN-zPZN$$

dans laquelle :

- PMN représente le magno-niobate de plomb ($Pb(Mg_{1/3}Nb_{2/3})O_3$)
- PT représente le titanate de plomb ($PbTiO_3$)
- PZN représente un zinco niobate de plomb ($Pb Zn_{1/3} Nb_{2/3})O_3$, caractérisée en ce que :
- la composition (en x, y, z) est située à la frontière (phase morphotropique) existant entre deux phases ferroélectriques de symétries différentes l'une étant de type relaxor ou à transition diffuse (pour le PMN) l'autre étant de structure cristallographique tétragonale (pour le PT);
- le lieu des points de composition est compris dans un quadrilatère délimité par des droites passant par les points suivants :

| | | |
|---|---|---|
| un premier point | A=x(PT)=25, y(PMN)=75 | z(PZN)=0, |
| un deuxième point | B=x(PT)=12, y(PMN)=28 | z(PZN)=60, |
| un troisième point | C=x(PT)=30, z(PZN)=60,y(PMN)=10 | |
| un quatrième point | D=x(PT)=50, y(PMN)=50 | z(PZN)=0, |

- et en ce que z est différent de zéro.

Les différents objets et caractéristiques de l'invention apparaîtront plus clairement dans la description qui va suivre et dans les figures annexées qui représentent :

- la figure 1, des courbes de températures optimales de frittage du matériau selon l'invention;
- la figure 2, des lieux de points de compositions du matériau de l'invention indiquant les coefficients de piézoélectricité $d_{33}$;
- la figure 3, des lieux de points de composition du matériau de l'invention;
- la figure 4, des lieux de points de compositions du matériau de l'invention indiquant les coefficients de charge hydrostatiques $d_h$;
- la figure 5, un tableau de résultats de mesures de matériaux selon l'invention.

Dans la solution solide PMN-PT, il existe une composition (vers 35% de PT) où coexistent la phase tétragonale et la phase pseudo-cubique (S.W. CHOI, T.R. SHROUT, S.J. LANG, A.S. BHALLA Ferroelectrics 1989, 100, 29-38). Cette composition, dite morphotropique, possède donc 14 directions de polarisation possibles, avec une forte valeur de polarisation spontanée $P_s$ pour chacune d'elle. Elle donne donc une polarisation macroscopique élevée après polarisation.

Cependant, selon l'invention, on augmente encore cette valeur en ajoutant une vraie phase rhomboédrique ayant une polarisation rémanente : c'est le cas du zinco-niobate de plomb ou PZN qui a en outre un très fort coefficient de charge dans le mode hydrostatique $d_h$ (KUWATA, J. Jap. J. Appl. Phys 1982), 21, 1298-1302).

Dans le diagramme binaire PZN-PT, il existe pour 10 % de PT une composition morphotropique entre la phase tétragonale du PT et la phase rhomboédrique du PZN. Mais cette composition n'a pas non plus des propriétés optimisées en raison de sa température de Curie trop basse (120°C) qui empêche le maintien de la polarisation rémanente, et de l'impossibilité de la synthétiser pure.

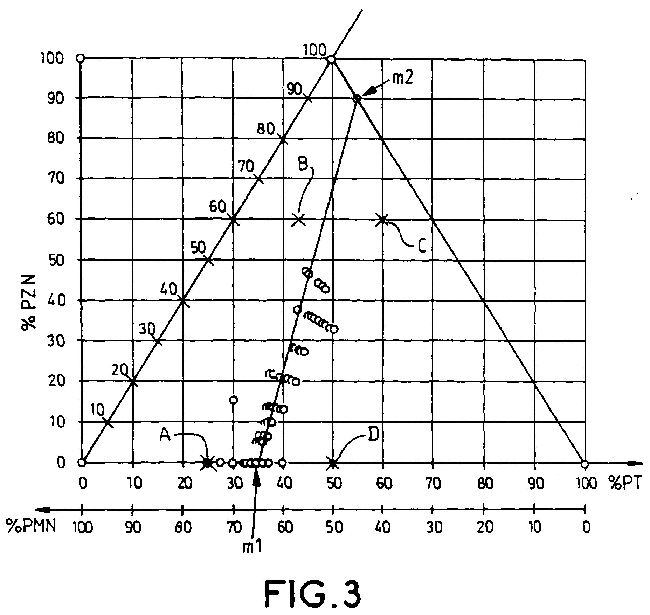

Donc dans le diagramme ternaire xPMN-yPT-zPZN selon l'invention, il existe une zone de compositions morphotropiques entre ces deux compositions PMN/PT 65/35 et PZN-PT 90/10, où coexistent -à température ambiante- la structure tétragonale du PT et la structure rhomboédrique du PZN. Cette zone est représentée sur la figure 3 sous la forme d'une ligne. Les compositions de cette zone possèdent des propriétés piézoélectriques supérieures à la composition PMN-PT et aux compositions plus classiques connues depuis longtemps (PZT ou $BaTiO_3$) avec en plus un fort coefficient de charge hydrostatique dû au PZN.

De façon générale, l'invention concerne donc une formule de céramique du type PMN-PT-PZN.

Plus précisément, cette céramique possède une phase morphotropique située entre deux phases ferroélectriques de symétries différentes l'une étant de type relaxor ou à transition diffuse.

Sur la figure 3, on a défini une zone de points fournissant des lieux de combinaisons intéressantes. Cette zone est définie par les quatre points A, B, C, D suivants :

un premier point A = x(PT) = 25, z(PZN) = 0, y(PMN) = 75
un deuxième point B = x(PT) = 12, z(PZN) = 60, y(PMN) = 28
un troisième point C = x(PT) = 30, z(PZN) = 60, y(PMN) = 10
un quatrième point D = x(PT) = 50, z(PZN) = 0, y(PMN) = 50

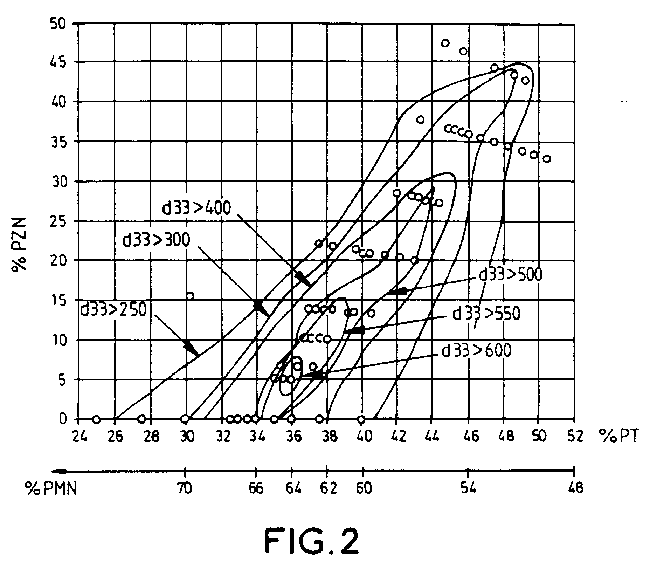

Cependant, cette zone peut être plus réduite comme cela se voit sur la figure 2 et se limiter par exemple aux zones pour lesquelles on a indiqué des coefficients piézoélectriques d33 supérieurs à 500, 550 ou 600.

Sur la figure 2, on a représenté la zone de compositions située à proximité de la droite de la figure 2 en indiquant les lignes d'égales valeurs des coefficients de charge piézoélectrique d33.

On constate que les différentes zones sont à proximité de la droite de la figure 3 (en pointillés sur la figure 2).

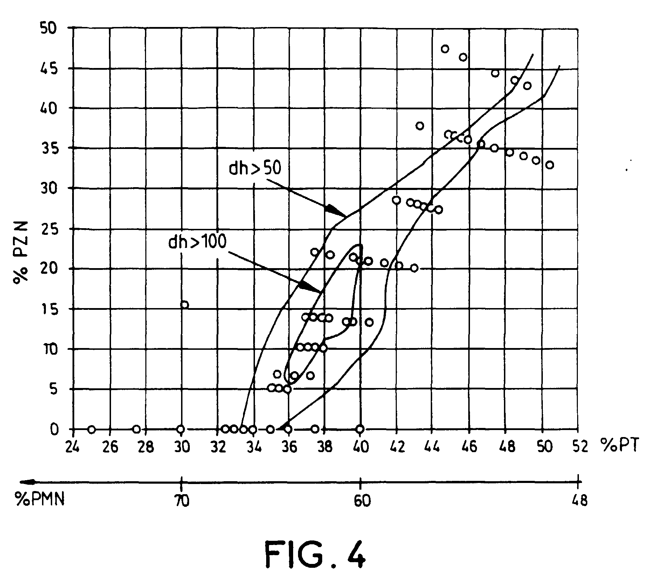

Sur la figure 4, on a représenté le même type de courbes pour les coefficients hydrostatiques dh.

On va maintenant décrire un procédé de fabrication d'une telle céramique.

La synthèse de la phase pérowskite PMN pure se fait de manière connue (S.L. SWARTZ et al, J. Amer. Ceram. Soc. 1984, 67, 311-315).

Au cours d'une première étape on réalise la synthèse d'une phase columbite $MgNb_2O_6$ à partir d'un produit à base de Mg tel que MgO ou $MgCO_3$ et d'un produit à base de Nb tel que $Nb_2O_5$.

Au cours d'une deuxième étape on réalise une réaction entre cette columbite et un produit à base de plomb tel que PbO pour former la pérowskite $Pb(Mg_{1/3}Nb_{2/3})O_3$.

Selon l'invention on prévoit d'ajouter le zinc lors de la première étape sous forme par exemple de ZnO. Puis lors de la deuxième étape on ajoute un produit à base de titane sous forme de $TiO_2$ par exemple.

L'ajout de titane permet d'obtenir le PMN-PT.

L'ajout de zinc permet d'obtenir le ternaire PMN-PT-PZN et on obtient une columbite de formule $Mg_xZn_x(Nb_2O_6)_{x+z}$.

L'incorporation du zinc favorise la formation de la phase columbite : pour une température de synthèse donnée, la quantité de phase non réagie diminue avec le taux de zinc.

Cette "columbite au zinc" est ensuite mélangée à PbO + $TiO_2$ pour former la composition de l'invention. Là aussi, l'ajout de zinc favorise la cristallisation de la phase pérowskite pure.

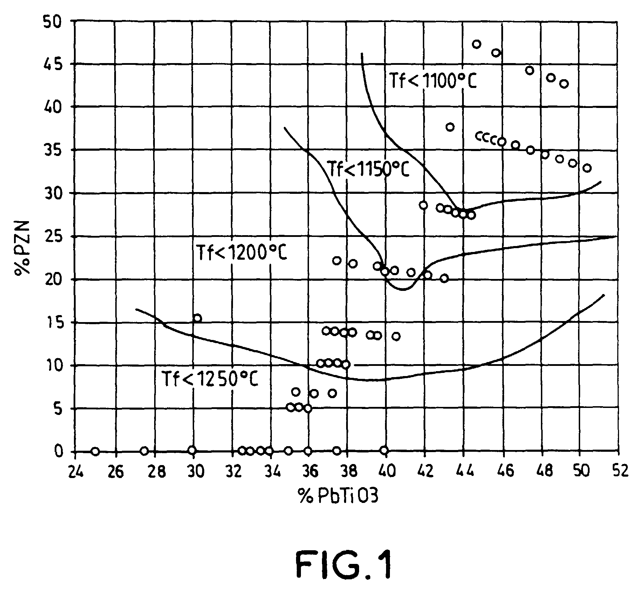

Le frittage des céramiques peut en outre être fait à des températures plus basses que pour le PMN/PT, le zinc agissant comme accélérateur de la densification. Le diagramme de la figure 1 montre les températures optimales de frittage (densification supérieure à 96 % de la densité théorique) le long de la ligne morphotropique du diagramme ternaire. On peut ainsi faire des céramiques piézoélectriques qui frittent à moins de 1100°C.

La polarisation de la céramique pour obtenir une céramique piézoélectrique se fait sous champ électrique à une température supérieure à 200°C.

Le matériau selon l'invention a été testé et les mesures ont été réalisées selon une méthode standardisée. Des barreaux, des plaques et des pastilles du matériau sont utilisées, avec des dimensions en accord avec la norme IRE. Ils sont métallisés par sérigraphie d'une pâte d'argent qui est ensuite cuite à 700°C pour favoriser l'accrochage. Les échantillons sont polarisés dans une étuve par refroidissement sous champ (200 V/mm) depuis une température (220°C) supérieure à la température de Curie de la transition ferroélectrique-paraélectrique. La mesure de l'impédance et de la phase en fonction de la fréquence, effectuée 24h après la polarisation, permettent de déterminer le tension des coefficients piézoélectriques ainsi que le facteur de qualité mécanique $Q_m$. La constante diélectrique et la tangente de pertes sont mesurés à 1 kHz.

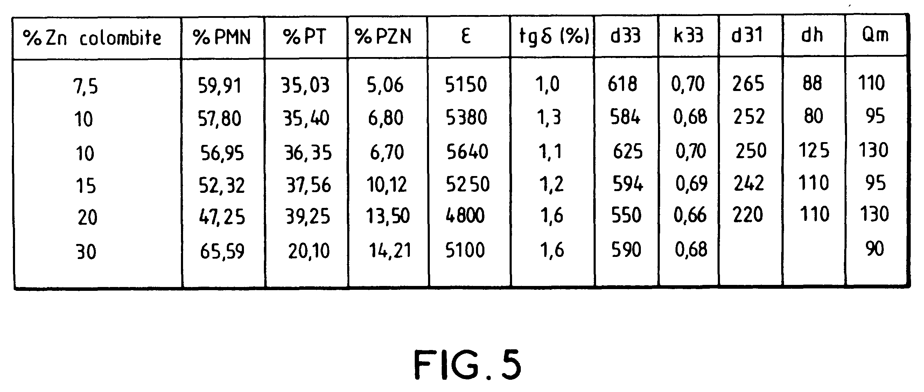

Le tableau de la figure 5 donne un extrait des propriétés électriques mesurées.

Le diagramme de la figure 2 qui a été décrit précédemment montre les régions du ternaire PMN/PZN/PT qui possèdent les meilleures valeurs de coefficient $d_{33}$. Elles se situent bien le long d'une ligne reliant les deux compositions binaires PMN/PT 65/35 et PZN/PT 90/10 de la figure 3. Dans la région obtenue avec des columbites à 10 % de Zinc, $d_{33}$ peut atteindre 630 pC/N, ce qui est meilleur que les compositions de PZT dites "douces" obtenues par dopage avec un on donneur. Les compositions de l'invention peuvent avoir en outre un facteur de qualité mécanique plus élevé ($Q_m$ > 130), une constante diélectrique plus élevée (e > 5500) et une tangente de pertes diélectriques plus faible (tg d < 1,2 %). Mais la propriété la plus intéressante de l'invention est le coefficient de charge hydrostatique $d_h$ qui atteint 125 pC/N (voir diagramme de la figure 4). Les meilleures compositions connues (PLT, métaniobate de plomb) ne dépassent pas 80 pC/N. Un $d_h$ élevé permet l'émission et la réception d'ultrasons dans l'eau avec un rendement accru. Cette propriété est due à la présente simultanée de PZN et de PT qui ont tous deux une forte anisotropie cristallographique. De ce fait, l'augmentation de $d_{33}$ le long de la ligne morphotropique du diagramme ternaire ne s'accompagne pas d'une augmentation consécutive du $d_{31}$ comme c'est le cas généralement. La différence $d_{33}$-2$d_{31}$ qui est égale à $d_h$ augmente donc.

**Revendications**

1. Céramique ferroélectrique de formule :

    xPT - yPMN - zPZN

    dans laquelle :

    - PMN représente le magno-niobate de plomb (Pb(Mg$_{1/3}$Nb$_{2/3}$)O$_3$)
    - PT représente le titanate de plomb (PbTiO$_3$)
    - PZN représente un zinco niobate de plomb (Pb Zn$_{1/3}$Nb$_{2/3}$)O$_3$, caractérisée en ce que :
    - la composition (en x, y, z) est située à la frontière (phase morphotropique) existant entre deux phases ferroélectriques de symétries différentes l'une étant de type relaxor ou à transition diffuse (pour le PMN) l'autre étant de structure cristallographique tétragonale (pour le PT);
    - le lieu des points de composition est compris dans un quadrilatère délimité par des droites passant par les points suivants:

        un premier point A=x(PT)=25, z(PZN)=0, y(PMN)=75
        un deuxième point B=x(PT)=12, z(PZN)=60, y(PMN)=28
        un troisième point C=x(PT)=30, z(PZN)=60,y(PMN)=10
        un quatrième point D=x(PT)=50, z(PZN)=0, y(PMN)=50

    - et en ce que z est différent de zéro.

2. Céramique ferroélectrique selon la revendication précédente, caractérisée en ce qu'elle possède une polarisation selon une direction non nulle.

**Claims**

1. Ferroelectric ceramic of formula:

    xPT-yPMN-zPZN

    in which:

    - PMN represents lead magno-niobate (Pb(Mg$_{1/3}$Nb$_{2/3}$)O$_3$)
    - PT represents lead titanate (PbTiO$_3$)
    - PZN represents a lead zinco-niobate (PbZn$_{1/3}$Nb$_{2/3}$)O$_3$, characterized in that:
    - the composition (en x, y, z) lies at the boundary (morphotropic phase) existing between two ferroelectric phases of different symmetries, one being of the relaxor or diffuse-transition type (in the case of PMN) and the other having a tetragonal crystallographic structure (in the case of PT);
    - the locus of the compositional points lies within a quadrilateral bounded by straight lines passing through the following points:

        a first point A=x(PT)=25, z(PZN)=0, y(PMN)=75
        a second point B=x(PT)=12, z(PZN)=60, y(PMN)=28
        a third point C=x(PT)=30, z(PZN)=60, y(PMN)=10
        a fourth point D=x(PT)=50, z(PZN)=0, y(PMN)=50

    - and in that z is other than zero.

2. Ferroelectric ceramic according to the preceding claim, characterized in that, along one direction, it possesses a non-zero polarization.

**Patentansprüche**

1. Ferroelektrische Keramik der Formel

    xPT-yPMN-zPZN

in welcher

- PMN ein Blei-Magnesiumniobat $(Pb(Mg_{1/3}Nb_{2/3})O_3)$ bedeutet,
- PT ein Bleititanat $(PbTiO_3)$ bedeutet,
- PZN ein Blei-Zinkniobat $(Pb\ Zn_{1/3}Nb_{2/3})O_3$ bedeutet, dadurch gekennzeichnet, daß
- die Zusammensetzung (in x, y, z) sich an der zwischen zwei ferroelektrischen Phasen mit verschiedenen Symmetrien existierenden Grenze (morphotropische Phase) befindet, wobei die eine Phase vom Relaxor-Typ oder mit diffusem Übergang (für das PMN) ist und die andere Phase eine tetragonale Kristallstruktur (für das PT) aufweist;
- der Ort von Punkten der Zusammensetzung in einem von Geraden begrenzten Vierecks enthalten ist, welche die folgenden Punkte durchqueren:

    einen ersten Punkt A=x(PT)=25, z(PZN)=0, y(PMN)=75
    einen zweiten Punkt B=x(PT)=12, z(PZN)=60, y(PMN)=28
    einen dritten Punkt C=x(PT)=30, z(PZN)=60, y(PMN)=10
    einen vierten Punkt D=x(PT)=50, z(PZN)=0, y(PMN)=50,

- und daß z verschieden von Null ist.

2. Ferroelektrische Keramik nach dem vorangehenden Anspruch, dadurch gekennzeichnet, daß sie eine Polarisation in einer Richtung aufweist, die nicht Null ist.

FIG.1

FIG.2

FIG.3

FIG. 4

| %Zn colombite | %PMN | %PT | %PZN | ε | tgδ (%) | d33 | k33 | d31 | dh | Qm |
|---|---|---|---|---|---|---|---|---|---|---|
| 7,5 | 59,91 | 35,03 | 5,06 | 5150 | 1,0 | 618 | 0,70 | 265 | 88 | 110 |
| 10 | 57,80 | 35,40 | 6,80 | 5380 | 1,3 | 584 | 0,68 | 252 | 80 | 95 |
| 10 | 56,95 | 36,35 | 6,70 | 5640 | 1,1 | 625 | 0,70 | 250 | 125 | 130 |
| 15 | 52,32 | 37,56 | 10,12 | 5250 | 1,2 | 594 | 0,69 | 242 | 110 | 95 |
| 20 | 47,25 | 39,25 | 13,50 | 4800 | 1,6 | 550 | 0,66 | 220 | 110 | 130 |
| 30 | 65,59 | 20,10 | 14,21 | 5100 | 1,6 | 590 | 0,68 | | | 90 |

## FIG.5

EP 0 666 244 B1